Europäisches Patentamt

European Patent Office

Office européen des brevets

(19)

(11) Veröffentlichungsnummer : **0 438 590 B1**

## (12) EUROPÄISCHE PATENTSCHRIFT

(45) Veröffentlichungstag der Patentschrift :
19.10.94 Patentblatt 94/42

(51) Int. Cl.⁵ : **H01S 3/025**, G02B 6/42

(21) Anmeldenummer : **90917935.0**

(22) Anmeldetag : **03.07.90**

(86) Internationale Anmeldenummer :
**PCT/EP90/01062**

(87) Internationale Veröffentlichungsnummer :
**WO 91/02392 21.02.91 Gazette 91/05**

(54) **INTEGRIERTES MIKROSYSTEM.**

(30) Priorität : **29.07.89 DE 3925201**

(43) Veröffentlichungstag der Anmeldung :
**31.07.91 Patentblatt 91/31**

(45) Bekanntmachung des Hinweises auf die
Patenterteilung :
**19.10.94 Patentblatt 94/42**

(84) Benannte Vertragsstaaten :
**FR GB**

(56) Entgegenhaltungen :
**EP-A- 0 171 615**
**EP-A- 0 251 718**
**DE-A- 1 917 005**
**DE-A- 3 630 700**
**US-A- 4 827 485**

(73) Patentinhaber : **Deutsche Aerospace AG**
**D-81663 München (DE)**

(72) Erfinder : **HALLDORSSON, Thorsteinn**
**Daphnestrasse 15**
**W-8000 München 81 (DE)**
Erfinder : **KROY, Walter**
**Beethovenstrasse 30**
**W-8012 Ottobrunn (DE)**
Erfinder : **PEUSER, Peter**
**Nelkenstrasse 46b**
**W-8011 Hohenbrunn-Riemerling (DE)**
Erfinder : **SEIDEL, Helmut**
**Moosbichlstrasse 1**
**W-8130 Starnberg (DE)**
Erfinder : **ZELLER, Paul**
**Sulzer-Belchen-Weg 27b**
**W-8000 München 82 (DE)**

**Beschreibung**

Die Erfindung betrifft ein Mikrosystem zur Halterung optischer, elektrischer u.a. Elemente sowie zur Aufnahme/Aufbringung/Anordnung elektronischer, elektrischer, hydraulischer, pneumatischer und/oder mechanischer Elemente und Einrichtungen sowie Mitteln zum Ein- und Auskoppeln von Energie, in jeglicher Form.

Stand der Technik und des technischen Gebiets auf dem die Erfindung liegt:

Die Entwicklungen in der Elektro-Optik für Kommunikation, Sensorik, Datenspeicherung, Steuer- und Regeltechnik gehen heute zunehmend in Richtung auf Mikro-Miniaturisierung und zur integrierten Elektro-Optik. Eine Miniaturisierung von Laser-Quellen war bis jetzt nur im Bereich der Halbleiterlaser möglich. Der Verkleinerung der Bauweise von Festkörperlasern stand der schlechte Wirkungsgrad der Umwandlung von elektrischer Leistung in Laserlicht, die Größe der Anregungsquellen, der Entladungslampen der optischen Bank und der einzelnen optischen Elemente, die noch in klassischer Bauweise hergestellt werden, im Wege.

Die Größe des optischen Kopfes von Dauerstrichlasern im Leistungsbereich von 1-100 W in herkömmlicher Bauweise ist typischerweise 10 x 10 x 20 cm und die Netzgeräte mit Kühlaggregaten haben, je nach Leistungsbereich, ein Gewicht von 10-100 kg. Für die Integration von Lasern in verschiedenen Systemen, z.B. in der Medizin, Materialbearbeitung, Holographie, Displaytechnik und Meßtechnik ist diese Größe der Geräte und vor allem der schlechte Wirkungsgrad sehr hinderlich und einer der wesentlichen Gründe für den relativ geringen Einsatz von Lasern in diesen Gebieten.

Eine Miniaturisierung von Festkörperlasern ist nicht nur aus diesem Grunde wünschenswert, sondern sie würde auch den Einsatz von automatisierten Fertigungsverfahren von Lasern und Laser-Elemente erheblich erleichtern.

Seit wenigen Jahren gibt es auf dem Markt Laserdioden mit GaAlAs Halbleitern, im Bereich 100 mW bis einige Watt optischer Dauerleistung als Array ausgebildet, die zur Anregung von Festkörperlasern geeignet sind. Der erste Laser dieser Art ist der diodengepumpte Nd:YAG-Laser mit der Emissionslinie $\lambda$ = 1,06 $\mu$m, der sich gegenüber dem konventionell mit Entladungslampen angeregten Laser, um einen etwa 10-fachen höheren elektrisch-optischen Wirkungsgrad auszeichnet.

Der Vorteil der Umsetzung der Strahlung einer Laser-Diode in Strahlung eines Festkörperlasers liegt in der erheblich besseren Strahlqualität des letzteren und seiner geringeren spektralen Bandbreite. Bezogen auf die spektrale Strahldichte wird hier eine Verbesserung um einen Faktor über $10^6$ erreicht.

Diodengepumpte Festkörperlaser sind z.B. in der Zeitschrift "Laser und Optoelektronik" 20 (3)/1988 Seiten 56-67 beschrieben.

Obwohl diese Laser einen deutlichen Fortschritt in Richtung Wirkungsgradsteigerung und Miniaturisierung aufweisen, werden die weiteren Bauteile wie Laserspiegel, Mikrosystem, Kühler, Strahlumlenker und Abbildungsoptik noch in konventioneller Technik hergestellt, die eine wesentliche Verkleinerung kaum ermöglicht. Ihre Größe übersteigt die der Basiselemente wesentlich, wie die der Laserdiodenarrays z.B. mit Dimensionen von 22 x 100 $\mu$m und dem Laserkristall mit 2 x 5 mm, z.B. um eine Größenordnung.

Eine einfache und wirtschaftliche Lösung der Kühlung einer Laserdiode und anderer optischer/elektronischer Elemente ist zur Zeit einer der dringlichsten Probleme zum Zwecke der Miniaturisierung und eine Aufgabe der Erfindung sowie deren Integration in eine geeignete Halterung.

Die Kühler für die Laserdioden, die meistens als Peltier- , Strahlungs- oder Flüssigkeitskühler angeboten werden, sind mehrfach größer und voluminöser als das Diodengehäuse, z.B. von der Größe TO3. Das Diodengehäuse selbst mit einem Durchmesser von 100 mm ist mehrfach größer als der Diodenchip selber mit einem Durchmesser unter 1 mm. Hier ist auch eine einfachere und wirtschaftlichere Lösung gefragt.

Eine Besonderheit des laserdiodengepumpten Festkörperlasers ist, daß die spektrale Lage der Emissionslinien der Diode genau an die effektivste Absorptionslinie des Lasermaterials angepaßt werden muß. Dies wird z.T. erreicht durch richtige Dotierung des Halbleiters. Da die Emissionswellenlänge des Halbleiters auch temperaturabhängig ist, muß die Temperatur je nach eingestelltem elektrischem Strom durch die Diode nachgeregelt werden. Als Meßgröße für die Regelung wird meistens die Ausgangsleistung des Festkörperlasers selbst verwendet und die Temperatur der Diode auf maximale Ausgangsleistung des Lasers nachgeregelt. Eine zweite Regelung ist notwendig, um die Ausgangsleistung der Laserdiode möglichst stabil zu halten. Hier wird die optische Leistung der Diode gemessen und bei einer eventuellen Änderung der Strom nachgeregelt. Beide Regelkreise greifen ineinander über und müssen gegenseitig abgestimmt werden. Integrierte Mikrosysteme gemäß der Erfindung sind in den Ansprüchen 1 und 6 definiert Ausführungsbeispiele sind in den abhängigen Ansprüchen aufgeführt.

Beschreibung der Erfindung im allgemeinen:

Die Erfindung hat es sich zur Aufgabe gemacht, eine wesentliche Miniaturisierung eines Mikrosystems und die Integration elektrischer und nichtelektrischer, insbesondere optischer Bauelemente wie z.B. diodengepumpte (Festkörper-)Laser-Systeme oder anderer Mikrosysteme und ihrer gegenseitigen Verbindungen elktrischer und nichtelektrischer Art zu erzielen, wobei Positionsveränderungen von Bauelementen/Bauteilen mit Vorteil steuerbar auszuführen sind.

Die grundlegende Lösung ist erfindungsgemäß hierbei als gemeinsame Basis das Mikrosystem, mit der Fixierung und gegenseitigen Justierung der einzelnen Elemente. Darüberhinaus soll diese Basis aber auch den Kühler zur Abführung der im Laser umgesetzten Wärme sowie elektronische Baugruppen zur Überwachung und Steuerung insbesondere der Laserfunktionen integrieren. Es wird hier vorgeschlagen, für diese integrale optische Bank ein Halbleitersubstrat zu verwenden. An erster Stelle kommt hierfür kristallines Silizium in Frage, das heute in der Mikroelektronik sehr große Verbreitung gefunden hat. Aber auch andere Halbleitersubstrate, wie z.B. GaAs oder InP können benutzt werden.

Durch die Verwendung eines Halbleitermaterials ist es möglich, die hochentwickelten Prozeßtechniken der Planartechnik sowie der Mikromechanik zu verwenden, die eine sehr genaue Strukturierung im Mikrometerbereich mit hoher Reproduzierbarkeit erlauben. Aufgrund der Batch-Verfahren ist ferner bei entsprechenden Stückzahlen mit einer sehr günstigen Preisentwicklung zu rechnen. Oberflächenmontage (SMD) und rechnergestützte Fertigung (CIM) ist anwendbar.

Dieses neue Substrat ist als gemeinsames Mikrosystem Basis eines Lasers mit präzisen Justierhilfen, bestehend aus Führungs- und Befestigungsgruben, versehen, in denen Einzelelemente wie Spiegelhalter, Abbildungselemente und Laserkristall mit bekannten Verbindungstechniken fixiert werden können. Diese Gruben werden mit den aus der Mikromechanik bekannten anisotropen Ätzverfahren erzeugt. Ferner sollen Wärmetauscherkanäle für die Flüssigkeitskühlung der wärmeerzeugenden Bauelemente, insbesondere der Pump-Laserdiode, aber eventuell auch für den Laserkristall und die Regelungselektronik, ebenfalls mit anisotropen Ätzverfahren, erzeugt werden. Zur Regelung dieser Kühlung ist die direkte Integration eines Temperaturfühlers am Ort der Laserdiode sowie der zugehörigen Regelelektronik vorgesehen. Auch ist die direkte Integration eines Mikroventiles zur Steuerung des Flüssigkeitsstromes möglich. Der Einsatz eines kleinen diskreten Einzelventils soll jedoch nicht ausgeschlossen werden. Weiterhin können Detektoren zur Überwachung der Strahlung der Pumpdiode und des Festkörperlasers mit der dazugehörigen Signalverarbeitungs- und Regelungselektronik zur Ansteuerung der Laserdiode auf der Basis integriert werden.

Für die Wahl des Halbleitermaterials, wie Silizium, sprechen neben den bekannten, hervorragenden elektrischen Eigenschaften auch sehr gute mechanische und thermische Eigenschaften, die in der nachfolgenden Vergleichstabelle zusammengefaßt sind:

|  | Si | Cu | Al | $SiO_2$ |
|---|---|---|---|---|
| Spez. Gew. $(g/cm^3)$ | 2,33 | 8,96 | 2,70 | 2,65 |
| E-Modul$*10^{12}$ $(dyn/cm^2)$ | 0,6-1,7 | 1,1 | 0,7 | 0,7 |
| Wärmekap. $(Ws/g\ K)$ | 0,71 | 0,38 | 0,90 | |
| Wärmeleitf. $(W/cm\ K)$ | 1,48 | 4,01 | 2,37 | 0,0132 |
| Therm. Ausdehn. $*10^{-6}$ | 2,4 | 16,6 | 25,0 | 1,5 |

Aus diesen thermo-mechanischen Materialdaten ist ersichtlich, daß Silizium gegenüber den metallischen Materialien für die mechanische Basis, Wärmeabfuhr und Temperaturregelung eines Lasers insgesamt wesentlich günstigere Eigenschaften besitzt. Noch weitreichender sind die Vorteile des Siliziums bei der Miniaturisierung, der Integration der vielfältigen mechanischen, thermischen, optischen und elektronischen Funktionen auf engem Raum und bei der Serienfertigung des gesamten Lasers, mit den o.a. aus der Mikroelektronik und der Mikromechanik bekannten Fertigungsverfahren.

Mit der Erfindung wird die Größe eines in Silizium o.a. Halbleitermaterial der Gruppe III bis V des periodischen Systems der Elemente hergestellten Laserkopfes mit optischer Bank im (z.B. Nd: YAG) Dauerstrichleistungsbereich von 1-100 W nur einige Zentimeter betragen und das Gewicht des Netz- und Kühlgerätes zwischen 1 und 10 kg liegen. Hiermit wird eine Reduzierung der Größe und des Gewichtes um eine Größenordnung gegenüber den herkömmlich hergestellten Lasern erreicht.

Beschreibung von Einzelheiten der Erfindung anhand von Ausführungsbeispielen:

Es zeigen:

Fig. 1 V-Grube 2 auf <100> Basis 1 als Justierhilfe für zylindrische Elemente 3,

Fig. 2 Justierhilfe für flächige Elemente durch anisotrop geätzte Vertiefungen in der Oberfläche der Basis 1,

Fig. 3    Integrierte Führung der Kühlkanäle 12 direkt in der optischen Bank,

Fig. 4    Führung der Kühlkanäle 12 in einer separaten <100> Si-Basis,

Fig. 5    Kühleinrichtung nach Art der Fig. 4 mit zusätzlichem integrierten Mikroventil 19,

Fig. 6    ein Schema des Mikrolasers 8 der optischen Bank,

Fig. 7    ein Schema ähnlich Fig. 6 mit Details, wie Spiegel (23 bis 25) und deren ortsveränderbarer Halterung/Lagerung 28,

Fig. 8    ein Schema ähnlich Fig. 6 auf X-Y Tisch für die Bewegung wenigstens einzelner Elemente des Mikro-Systems einsprechend den Pfeilen.

Die in dem ersten Ausführungsbeispiel realisierten verschiedenen Einzelfunktionen des Laser-Systems sollen nun näher erläutert werden. Die grundlegende Eigenschaft des Mikrosystems eines Lasers ist die Justierbarkeit und Befestigung der einzelnen Funktionselemente gegenüber der gemeinsamen optischen Achse. Beim Laser ist eine exakte Positionierung in allen drei Raumkoordinaten (x,y,z) und um die zwei Raumwinkel in Azimuth und Elevation ($\phi,\psi$) notwendig. Die Toleranzen betragen in der Position etwa 0,1 mm und im Winkel etwa $10^{-4}$rad.

Die Erfindung geht davon aus, daß jedes Teil in einer festen Lage unbeweglich fixiert wird, wie es bei modernen Lasern üblich ist. Für eine Serienfertigung muß somit vorausgesetzt werden, daß Einzelteile wie Spiegel, Laserkristall oder Umlenk- und Abbildungsoptiken inklusive ihrer Halterungen mit den nötigen engen Toleranzen vorgefertigt werden können. Dann ist es möglich, die erforderliche Justiergenauigkeit durch exakte Positionierung von Justierhilfen in der als Mikrosystem ausgebildeten Basis 1 zu erzielen. Diese Justierhilfen können, je nach Form des zu positionierenden Gegenstandes (wie z.B. 8), unterschiedlich beschaffen sein:

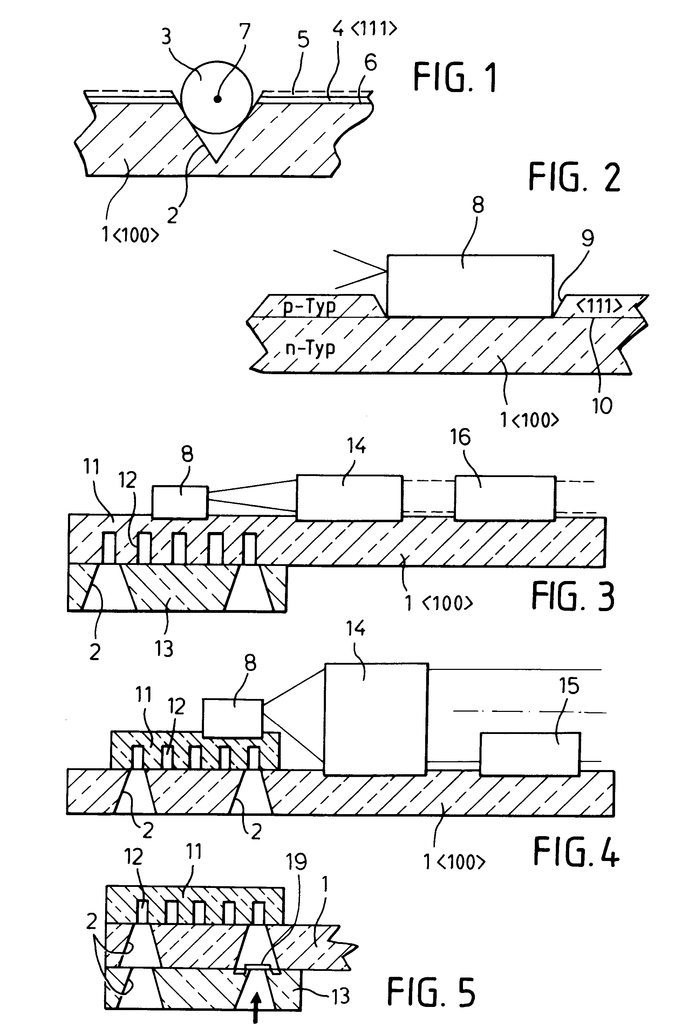

Zur Justierung von zylinderförmigen Elementen 3, wie z.B. vom Laserkristall oder der erforderlichen Abbildungsoptik, bietet sich die Verwendung von kristallografisch festgelegten V-Gruben 2 an. Es wird vorgeschlagen, eine Halbleiterbasis der Kristallorientierung (100) zu verwenden und die V-Gruben mit Hilfe der (111) Kristallebenen, die einen Neigungswinkel von 54,7° gegenüber der Basisoberfläche aufweisen, zu bilden. Dazu wird die Basis mit einer Passivierungsschicht 4 wie z.B. $SiO_2$ oder $Si_3N_4$ bedeckt und fotolithografisch strukturiert. Anschließend wird anisotrop mit den bekannten Ätzlösungen (z.B. KOH oder Ethylendiamin-Wasser) geätzt. Durch die geometrischen Abmessungen der Ätzmaske 5 ist die resultierende Geometrie der V-Grube mit hoher Präzision festgelegt. Auch die Höhe der optischen Achse 7 bezogen auf die Basisoberfläche 6 läßt sich bei bekanntem Durchmesser (Radius r) des zu justierenden Objektes (opt. Teil) sehr genau einstellen (siehe Fig. 1). Die geringe Restätzrate der (111) Kristallebenen kann bei der Auslegung der Lithografiemaske berücksichtigt werden, so daß Genauigkeiten im Mikrometerbereich erzielt werden können.

Zur Justierung von flächigen Elemente, wie z.B. der (Laser-)Diode 8, können Vertiefungen 9 in die Halbielterbasis 1 geätzt werden, die ebenfalls von <111>-Kristallflächen begrenzt werden. Um die Ätztiefe genau zu definieren, kann ein Ätzstop zeitweise (nicht dargestellt) eingebaut werden. Eine Möglichkeit besteht in der Erzeugung eines pn-Übergangs 10 in der gewünschten Tiefe mittels Epitaxie oder Ionenimplantation. Durch elektrochemisches, anisotropes Ätzen erfolgt ein sehr präziser Stop an der Grenzschicht 10. Als weitere Möglichkeit können hochbordotierte Schichten verwendet werden, an denen ebenfalls ein Ätzstop erfolgt. Ein Beispiel hierzu ist in Fig. 2 dargestellt.

Wenn, wie Fig. 3 zeigt, ein Kühlelement 11 zu integrieren ist, kann es, wie im folgenden beschrieben, auch von Vorteil sein, wenn das Substrat 1 die Kristallorientierung (110) besetzt. Dort werden V-Gruben 2 mit einem Flankenwinkel von 35,3° zur Scheibenoberfläche für die Kühlwasserführung genutzt. Ferner erlaubt dieser Basistyp die Herstellung von Kanälen 12 mit senkrechten Flanken.

Für das Fixieren der Elemente 3 in den Justierhilfen stehen verschiedene Verfahren zur Verfügung. Glasteile 13 können gut mit Siliziumteilen 11 durch die sog. anodische Verbindungstechnik verbunden werden. Dazu werden die Teile auf 400 - 500 °C erhitzt und eine Spannung von 500 - 1000 V angelegt. Die Verbindung kommt ohne eine Zwischenschicht zustande. Eine andere Möglichkeit besteht in der Verwendung von niedrigschmelzenden Glasloten, die auch als Dünnfilm aufgebracht werden können, und durch Erhitzung zu einer stabilen Verbindung führen. Ein weiteres Verbindungs-Verfahren besteht in der Verwendung von eutektischen Materialien, z.B. Si-Au, das bei 370 °C ein Eutektikum bildet. Dazu wird auf das zu verbindende (Glas-)Teil eine Goldschicht aufgedampft und dann auf das Siliziumteil 11 (od. 1) gelegt - oder umgekehrt - und über den eutektischen Punkt erhitzt. Falls nur niedrige Temperaturen bei der Verbindung erlaubt werden können, kommen Klebetechniken mit geeigneten Ein- oder Mehrelemente-Klebern zur Anwendung.

Die zweite Aufgabe des Mikrosystems ist die Wärmeabfuhr von heißen Teilen. Das betrifft vor allem die Laserdiode 8 und, mit Einschränkungen, auch die anderen Teile der Optik 14, der Elektronik 15 sowie bei sehr hohen Pumpleistungen den Laserkristall 16. Typische Werte des elektrisch-optischen Wirkungsgrades der Laserdiode liegen z.Z. bei 40-50%, d.h. 50-60% der Leistung werden in Wärme umgesetzt. Typische Ausgangsleistungen der Dioden 8 liegen z.Z. im Bereich von 100 mW bis 5W, so daß entsprechende Wärmeleistungen von einem sehr kleinen Volumen von einer Größe weit unter 1mm³ abgeführt werden müssen. Die effektivste Art der Kühlung ist die mit Flüssigkeit. Die Erfindung sieht Wasser als Kühlmittel vor. Dazu können Kühlkanäle 12 in das Halbleitersubstrat 1 integriert werden.

Diese Kühlkanäle 12 können ebenfalls durch anisotropes Ätzen erzeugt werden. Am besten eignet sich hierfür eine Basis 1 der Kristallorientierung (110), da dort sehr tiefe und, falls erforderlich, auch sehr schmale Kanäle 12 mit senkrechten Flanken erzeugt werden können. Für die prinzipielle Anordnung gibt es zwei Möglichkeiten (Fig. 3 und Fig.4).

Zum einen können die Kanäle 12 direkt in das Mikrosystem eingeätzt werden und von einem zweiten, darunterliegenden Teil 13, das die Zuführungskanäle 2 enthält, abgedichtet werden. Diese Anordnung ist in Fig. 3 dargestellt.

Zum anderen besteht die Möglichkeit, die Laserdiode 8 auf ein eigenes, kleines Teil 11 zu montieren, in das die erforderlichen Kühlkanäle 12 eingeätzt werden und dann diese Gesamteinheit auf das Mikrosystem zu montieren (siehe Fig. 4). Dann muß die Basis 1 des Mikrosystems die Dichtfunktion übernehmen sowie die erforderlichen Zuführungskanäle 2 enthalten. Die erstgenannte Möglichkeit setzt voraus, daß die Basis des Mikrosystems selbst die Kristallorientierung (110) besitzt. Dies muß bei der Auslegung der Justierhilfestrukturen berücksichtigt werden und führt insofern zu einer Verkomplizierung gegenüber (100) der Baisis, als dann keine rechtwinklige Symmetrie mehr zur Verfügung steht. Bei der zweiten Möglichkeit kann bei der Basis 1 des Mikrosystems die Orientierung (100) beibehalten werden. Allerdings wird hier der Justiervorgang aufwendiger, da die Diode 8 auf dem Zwischenteil 11 und anschließend das Zwischenteil auf der Basis 1 des Mikrosystems mit hoher Genauigkeit positioniert werden müssen.

Die Temperatur der Diode 8 muß üblicherweise mit einer Genauigkeit von 0,1°C geregelt werden. Da der Diodenstrom und damit die Ausgangsleistung steuerbar sein muß, ist eine Regelung der Kühlung unerläßlich. Die Erfindung sieht vor, daß der Kühlwasserstrom (Zufuhr, Abfuhr, Durchsatz) über wenigstens ein Ventil 19 in Abhängigkeit der Temperatur der Diode 8 gesteuert wird. Dieses Ventil ist im einfachsten Fall ein diskretes Dosierventil, das in hybrider Bauweise integriert wird. In Weiterbildung der Erfindung ist jedoch vorgesehen, als Ventil 19 ein Mikroventil direkt in das Mikrosystem zu integrieren. Dies kann z.B. in der Bauform nach Patent DE 36 21 331 C2 geschehen. Eine mögliche Ausführung hierzu ist in Fig. 5 dargestellt.

Zur Erfassung der Temperatur bietet sich an, einen Temperaturfühler 20, z.B. in Form eines temperaturabhängigen Widerstandes, direkt am relevanten Ort (z.B. an der Diode 8) in das Mikrosystem zu integrieren. Als Widerstandsmaterial kommen z.B. Dünnfilme aus Platin, Nickel oder aus polykristallinem Silizium in Frage.

Die Erfindung sieht weiterhin vor, daß die optische Ausgangsleistung der Laserdiode 8 sowie des Laserkristalls 11 ständig überwacht werden. Dies geschieht dadurch, daß ein Teil der Strahlung (von 8) auf einen optischen Detektor 21, wie eine Photodiode, geleitet wird. Kurzzeit- und Langzeit-Schwankungen der Ausgangsleistung der Diode 8 bzw. des Festkörperlasers können damit über den Diodenstrom ausgeglichen werden. Diese Überwachung und Regelung der Ausgangsleistung (von 8) bietet letztendlich auch die Möglichkeit einer indirekten Temperaturerfassung, da Temperaturschwankungen zu einer Verminderung der Leistung führen. Die elektronische Regelung ist so auszulegen, daß die Ausgangsleistung des Lasers ständig im optimalen Bereich gehalten wird.

Die für das Gesamtsystem erforderliche Elektronik 15, wie z.B. Sensorsignal-Vorverstärker, Signalverarbeitungs- und. -auswerteschaltung und Regelschaltung für den Diodenstrom (von 8) bzw. für das Steuern (mit Ventil 19) der Kühlung werden im allgemeinen aus ökonomischen Gründen als kundenspezifische IC's separat gefertigt und auf das Mikrosystem aufgebondet.

Dabei können auch Vorrichtungen zur Kühlung der IC's mit hohen Verlustleistungen (z.B. zur Regelung des Diodenstromes) in dem Mikrosystem in der oben beschriebenen Weise mit vorgesehen werden. Die Anforderungen an die Temperaturkonstanz sind hier wesentlich entspannter (ca. +- 10°C) als bei der Pumpdiode. Hier können auch eingebaute Wärmesenken ausreichen, insbesondere wenn Wärmebarrieren in Form von V-Gruben 2 dazwischen eingelassen sind.

Bei der Erfindung ist jedoch auch vorgesehen, die gesamte erforderliche Elektronik unmittelbar in das Mikrosystem mit zu integrieren. Dies kann unter Nutzung einer Standard-Schaltkreistechnologie, wie z.B. CMOS oder Bipolar, erfolgen. Dadurch ist ein Höchstmaß an Miniaturisierung und Störsicherheit des Gesamtsystems zu erreichen. Der IC der Elektronik 15 kann auch die Steuerung für die relative Lage-/Positions-/Abstands-/Aktuatoren- bzw. Stellglieder optischer Teile enthalten.

Ferner ist vorgesehen, daß auf dem Mikrosystem aus Silizium oder einem anderen Halbleitermaterial als Basis 1 ebenso andere optische Teile, insbesondere aus mikromechanisch strukturiertem Silizium befestigt werden. Die für den Laserresonator eingesetzten Spiegel 23, 24 sind als mikromechanische, elektrisch ansteuerbare Teile der Optik 14 besonders vorteilhaft. Mit solchen Spiegeln wird über die gesamte Betriebs- und Lebensdauer der Anordnung die ständige automatische Nachjustierung des Resonators 26 ermöglicht.

Erfindungsgemäß werden hierzu eine oder mehrere Kontrolldioden 21 im Außenbereich 25 des Resonators 26 so angeordnet, daß die integrale Intensität der Ausgangsstrahlung oder andere Strahlparameter, wie z.B. der Strahldurchmesser, die Modenstruktur, die Strahlrichtungoder die zeitliche Modulation der Strahlung fortlaufend elektronisch registriert werden. Die Meßwerte werden mit extern vorgegebenen Sollwerten verglichen und bei zufällig oder durch äußere und innere Störeinflüße wie Erschütterungen, Strom- und Spannungsschwankungen auftretenden Abweichungen, werden entgegenwirkende Stellsignale für Aktuatoren erzeugt, welche die Positionen oder Bewegungen oder Biegungen der mikromechanischen Spiegel der Optik oder anderer optischer Teile wie mikromechanischer Strahlformer (Blenden, Ringschlitzen, Prismen, Spalte usw.) verändern. Die Steuerkräfteerzeugung und -einwirkung kann dabei auf thermische, mechanische, fluidische, elektrische, magnetische, thermomechanische, magnetostriktive, elektromagnetische, piezoelektrische oder elektrostatische Weise erfolgen.

Durch die erfindungsgemäße Steueranordnung wird die Lebensdauer eines Lasers - im Gegensatz zu heutigen Lasern -, weil Justiereingriffe oder mechanische oder elektrische Wartungsarbeiten nicht mehr erforderlich sind, wesentlich erhöht.

Entsprechend fallen äußere Justiermechaniken und dergleichen weg, was eine weitere Verkleinerung des Produktes ermöglicht. Das neue Mikrosystem ist gänzlich über einen Mikrocomputer und Rechnersoftware steuerbar, was für den Nutzer eine erhebliche Vereinfachung, Erhöhung der Betriebssicherheit und Flexibilität bedeutet. Durch die Integration fluider, mechanischer, elektrischer und optischer Elemente auf sehr kleinem Raum fallen eine Vielzahl von Steckern und Leitungen weg, die üblicherweise ca. 50% der Fehler und Betriebsunfälle verursachen. Die erfindungsgemäße Anordnung weist dadurch eine besonders hohe Zuverlässigkeit auf, insbesondere weil große bewegliche Teile, die Verschleiß unterliegen, entfallen.

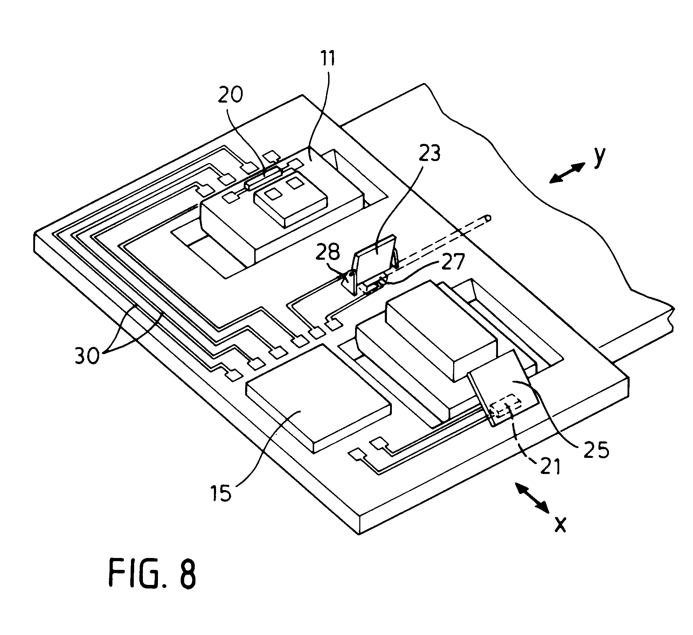

Die erfindungsgemäße Basis aus einkristallinem Halbleitermaterial eignet sich auch für den direkten Einbau/Integration von Kopplern, insbesondere Opto-Kopplern, wie Lichtleiter, etwa wie in der Zeitschrift "Laser und Optoelektronik" 20(3)/1988, Seite 66 beschrieben und in Abb. 8, 9 und 10 dort dargestellt oder auch in EP 0 197 117 B1.

Nicht nur Halblelterlaser/Festkörperlaser als (Licht-)Sender, sondern auch (Licht-)Empfänger für elektromagnetische Strahlung sind so auf einem gemeinsamen Mikrosystem anzuordnen. Die Signalausgabe und -auswertung kann optisch/elektrisch oder kontinuiert (optimiert) erfolgen. Die Anwendung kann allgemein für meßtechnische Zwecke erfolgen, aber auch für andere Zwecke, wie die der Steuerungs-, Regel-, Analysen- und der Nachrichtentechnik, insbesondere in Verbindung mit Lichtwellenleitern.

Die Erfindung ist nicht auf die Art der beschriebenen Sensoren, Aktuatoren, Antriebe, Steuer- und Regeleinrichtungen für eine Aufbau mit mikromechanischer Basis beschränkt, noch auf elektrische oder nichtelektrische Elemente und deren bekannte Verbindungsmöglichkeiten sowohl fest als auch beweglich. Energie jeglicher Form auch nach Umwandlung ist ein- und auskoppelbar und anwendbar für alle Zwecke der Erfindung, insbesondere nach den Ansprüchen.

Die Erfindung ist nicht auf die angegebenen Ausführungsbeispiele beschränkt.

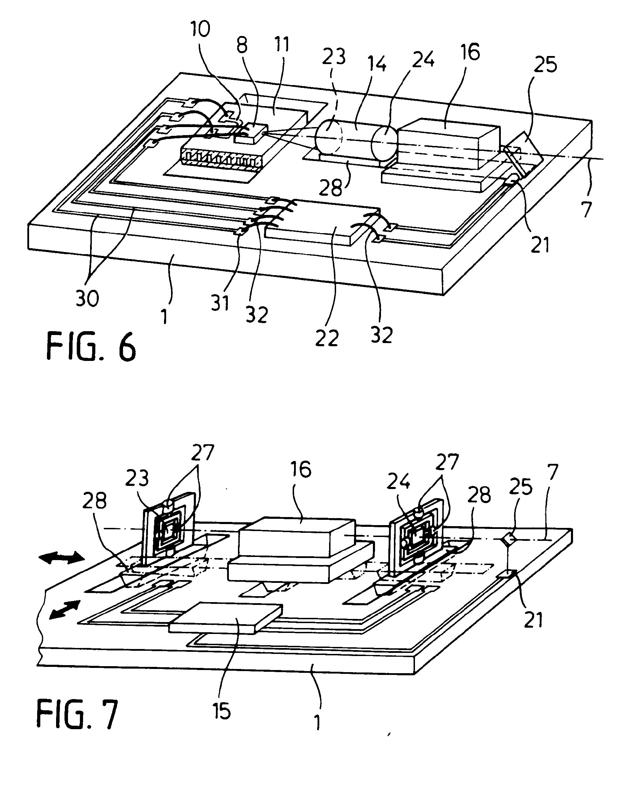

Während in den Figuren 1 bis 5 Einzelheiten einer mikromechanischen Basis als Mikrosystem dargestellt sind, enthält Fig. 6 eine schematische Darstellung des Gesamtaufbaus.

In Fig. 7 ist - abweichend zur Fig. 6 - die Halterung 28 für optische Teile, wie Spiegel 23, 24 ersichtlich. Dazu sind die Halteteile 28 so ausgebildet, daß diese aus je zwei Balken in Form der V-Gruben 2 kreuzförmig (ineinander) z.B. elektrisch, magnetisch, fluidisch (mittels Überdruck/Unterdruck) verschiebbar und/oder versetzbar sind (vgl. die Pfeile für mögliche Schiebebewegung in X-Y-Richtung). Die Spiegel 23, 24, 25 sind kardanisch aufgehängt und sind von Aktuatoren 27 bewegbar, insbesondere schwenkbar, drehbar, längs und/oder quer, sowie relativ zu anderen Elemente, Teilen, Elementen des Systems und der Basis 1, auch auf andere Niveaus (Z-Richtung).

In Fig. 8 ist - ähnlich zur Fig. 7 - das System auf einem X-Y-Tisch angeordnet bzw. bildet die Basis 1 einen Teil eines solchen Tisches, welcher von außerhalb insbesondere programmgesteuert wird von einem Mikroprozessor oder Mikrocomputer, etwa nach Art bekannter X-Y-Tische, wie in EP 0 149 017 B1 beschrieben oder X-Y-Z-Tische wie in EP 0 319 602 A1 beschrieben.

Die Aktuatoren/Stellantriebe und/oder Justierhilfen und/oder Regelung für Positionsänderungen einzelner Bauelemente/Bauteile und ihre Steuerung können vom Fachmann je nach Anwendungsfall der Erfindung ausgewählt und daran angepaßt werden. Gleiches gilt für die Art der Quelle, Kühlung, Wärmeabfuhr, Wärmesenke, ohne auf die beschriebenen Ausführungen beschränkt zu sein.

Je nach Anwendungsfall können externe Rechner, Prozessoren, elektronische Steuerungen, Regelungen, Auswerte- und Dokumentations- (Speicher-)einrichtungen angeschlossen werden.

EP 0 438 590 B1

**Patentansprüche**

1. Integriertes Mikrosystem mit elektrischen und nichtelektrischen, insbesondere optischen Funktionen in einem Lasersystem, **gekennzeichnet** durch eine Basis (1) aus anisotrop ätzbarem einkristallinem Halbleitermaterial, wobei in der Oberfläche der Basis Ätzstrukturen zur Aufnahme optischer (14) und/oder elektrooptischer Elemente (8, 16) und elektrisch/elektronischer und/oder fluidischer und/oder mechanischer Elemente oder deren Halterungen in vorgegebenen Abständen und/oder Niveaus sowie integrierte Schaltkreise angeordnet sind, und dadurch daß zumindest ein Teil der optischen, elektrooptischen oder mechanischen Elemente oder deren Halterung elektrisch derart ansteuerbar und bewegbar ist, daß ihre Position relativ zur Basis aktiv veränderbar ist und daß zumindest ein Sensor (21) vorgesehen ist, der die Auswirkung der Positionsveränderung auf die Funktion wenigstens eines Teil, d.h. eines Mikrosystems erfaßt und ein Signal zum wiederholten Nachstellen, d.h. Selbstjustieren, optischer Elemente (23,24) und deren Halterungen (28) liefert.

2. Integriertes Mikrosystem nach Anspruch 1, **dadurch gekennzeichnet**, daß es zum Einstellen eines diodengepumpten Festkörperlasers (8) entlang einer Achse (optische Achse 7) und dessen Steuerung/Regelung/Kühlung, Ein- und Auskopplung von Energie ausgebildet ist.

3. Integriertes Mikrosystem nach einem der vorhergehenden Ansprüche, **dadurch gekennzeichnet,** daß es elektronische Schaltungen (22), insbesondere Steuer- und Regelkreise für das Lasersystem und ihre Verbindungen, Sensoren (21), Aktuatoren (27) enthält.

4. Integriertes Mikrosystem nach einem der vorhergehenden Ansprüche, **dadurch gekennzeichnet,** daß es Mittel (12) zum Wärmeaustausch, insbesondere zur Kühlung des Lasersystems enthält.

5. Integriertes Mikrosystem nach einem der vorhergehenden Ansprüche, **dadurch gekennzeichnet,** daß die aktive Selbstjustierung des diodengepumpten Festkörperlasers (8) über die gesamte Betriebsdauer des Lasers wirksam ist, um eine Sollposition wenigstens einiger optischer Elemente einzuhalten.

6. Integriertes Mikrosystem für elektrische und nichtelektrische, insbesondere optische Mittel eines Lasersystems, **dadurch gekennzeichnet**, daß es eine Basis (1) aus anisotrop ätzbarem einkristallinem Halbleitermaterial aufweist, die die mechanische Trägerfunktion für Elemente eines Festkörperlasers (8) mit Pumpdiode, wie Optik (14), Resonatoren (23,24), Laserkristall (16) und Fluidik/Elektronik (15) übernimmt, daß es mit Justierhilfen wie V-Gruben (2) und Vertiefungen als Ätzstrukturen in der Oberfläche der Basis zur exakten Positionierung der Elemente versehen ist und daß die Basis (1) zugleich als Kühlkörper der leistungsintensiven Elemente durch eingebaute Flüssigkeitskühlkanäle (12) dient.

7. Integriertes Mikrosystem nach Anspruch 6, **dadurch gekennzeichnet**, daß bei Elementen des diodengepumpten Lasers (8), die einer besonders hohen Justiergenauigkeit bedürfen, wie Resonatorspiegeln, Strahlumlenker, Strahlformer (23 bis 26) ihre Halterung so ausgebildet ist, daß sie mit Aktuatoren (27) die in der Basis (1) eingebaut sind, exakt justierbar sind durch Nachstellen in eine Sollposition, wobei das Steuersignal aus dem Meßsignal von Laserstrahlungssensoren (21), die mit der Steuerelektronik (15, 22) in dem Mikrosystem integriert sind, abgeleitet wird.

8. Integriertes Mikrosystem nach Anspruch 6, **dadurch gekennzeichnet**, daß veränderliche Elemente des Lasersystems nur einmal kurz nach der Herstellung in ihrer Lage, Abstand und dgl., insbesondere durch Verschieben in V-Gruben (2) der Basis (1) in einer Ausgangsposition justiert werden und daß andere Elemente für die Betriebsdauer des Lasers (8) in diesem Zustand mit Gießmitteln, Klebemitteln oder Löt- bzw. Schweißmitteln gefesselt werden.

9. Integriertes Mikrosystem nach Anspruch 6, **dadurch gekennzeichnet,** daß die Steuerung der Lage von Elementen des Lasersystems (8), insbesondere optischen Elementen des Systems, mechanisch/elektrisch, magnetisch, thermisch, fluidisch, mittels Aktuatoren (27) oder durch Antriebe erfolgt.

10. Integriertes Mikrosystem nach Anspruch 6, **dadurch gekennzeichnet,** daß die Steuerung der Lage von Elementen des Lasersystems (8), insbesondere von optischen Elementen des Systems, fluidisch erfolgt durch Strömungsbewegung eines Mediums, das zu- oder abgeführt wird.

11. Integriertes Mikrosystem nach Anspruch 6, **dadurch gekennzeichnet,** daß Wärmebarrieren durch die anisotrop geätzten V-Gruben (2) zwischen Bereichen mit Elementen unterschiedlicher Temperaturanforderungen erfaßt (20) in dem Mikrosystem gebildet sind.

**12.** Integriertes Mikrosystem nach Anspruch 6, **dadurch gekennzeichnet,** daß Kühlkanäle (12) aus parallelen V-Gruben (2) in Richtung des Kristallgitters der Halbleilterbasis möglichst nahe an dem Diodenlaser (8) angeordnet sind.

## Claims

**1.** Integrated micro system with electrical and non-electrical, in particular optical functions in a laser system, **characterised by** a base (1) of anisotropically etchable mono-crystalline semi-conductor material, in which respect in the surface of the base are arranged etching structures to receive optical (14) and/or electro-optical elements (8, 16) and electric/electronic and/or fluid and/or mechanical elements or their supports at specified distances and/or levels as well as integrated switching circuits, and that this allows at least a portion of the optical, electro-optical or mechanical elements or their supports to be electrically controlled and moved in such a manner that their position relative to be base is actively changeable and that at least one sensor (21) is provided which detects the effect of a change in position on the function of at least a portion of the micro system and which delivers a signal for repeated re-setting, i.e. self-adjustment, of optical elements (23, 24) and their supports (28).

**2.** Integrated micro system according to claim 1, **characterised in that** it is designed for setting a diode-pumped solid-state laser (8) along an axis (optical axis 7) and its control/regulation/cooling and for coupling energy in and out.

**3.** Integrated micro system according to one of the above claims, **characterised in that** it contains electronic circuits (22), in particular control and regulating circuits for the laser system and its connections, sensors (21), actuators (27).

**4.** Integrated micro system according to one of the above claims, **characterised in that** it contains means (12) for heat exchange, in particular for cooling the laser system.

**5.** Integrated micro system according to one of the above claims, **characterised in that** the active self-adjustment of the diode-pumped solid-state laser (8) is effective during the entire duration of operation of the laser in order to maintain a nominal position of at least some optical elements.

**6.** Integrated micro system for electrical and non-electrical, in particular optical means of a laser system, **characterised in that** it comprises a base (1) of etchable mono-crystalline semiconductor material which takes over a mechanical carrier function for elements of a solid-state laser (8) with pump diode, such as an optics (14), resonators (23, 24), laser crystal (16) and fluid/electronics (15), that it is provided with adjusting aids such a V-grooves (2) and recesses as etching structures in the surface of the base for exact positioning of the elements, and that the base (1) serves simultaneously as a cooling element of the output-intensive elements by way of built-in liquid-cooling channels (12).

**7.** Integrated micro system according to claim 6, **characterised in that** elements of diode-pumped lasers (8) which require a particularly high accuracy of adjustment, such as resonator mirrors, beam deflectors, beam formers (23 to 26) have their support structured in such a manner that they are precisely adjustable with actuators (27) which are built into the base (1) by resetting into a nominal position, in which respect the control signal is derived from the measuring signal of laserbeam sensors (21) which are integrated with the control electronics (15, 22 into the micro system.

**8.** Integrated micro system according to claim 6, **characterised in that** changeable elements of the laser system are only once briefly adjusted in an initial position after having established their position, distance and the like, in particular by displacement in V-grooves (2) of the base (1), and that other elements are fixed in this state for the operational period of the laser (8) by means of pourable substances, adhesive means or soldering or welding means.

**9.** Integrated micro system according to claim 6, **characterised in that** the position control of elements of the laser system (8), in particular of optical elements of the system, is carried out mechanically/electrically, magnetically, thermally, fluidically, by way of actuators (27) or by drives.

10. Integrated micro system according to claim 6, **characterised in that** the position control of elements of the laser system (8), in particular of optical elements of the system, is carried out fluidically by flow-movement of a medium which is delivered or removed.

11. Integrated micro system according to claim 6, **characterised in that** heat barriers are formed in the micro system by anisotropically etched V-grooves (2) between the areas of elements of different temperature requirements (20).

12. Integrated micro system according to claim 6, **characterised in that** the cooling channels (12) of parallel V-grooves (2) in the direction of the crystal lattice of the semi-conductor base are arranged as near as possible to the diode laser (8)

## Revendications

1. Microsystème intégré avec des fonctions électriques et des fonctions non électriques, notamment des fonctions optiques, dans un système de laser, caractérisé par un substrat (1) en matériau semiconducteur monocristal pouvant être soumis à une attaque chimique anisotrope, des structures obtenues par attaque chimique destinées à recevoir des éléments optiques (14) et/ou électro-optiques (8, 16) et des éléments électriques/électroniques et/ou fluidiques et/ou mécaniques ou des supports pour ceux-ci ainsi que des circuits intégrés étant disposés à des distances et/ou des niveaux prédéterminés dans la surface du substrat et par le fait qu'une partie au moins des éléments optiques, électro-optiques ou mécaniques ou de leurs supports peuvent être commandés et déplacés par des moyens électriques de manière telle que leur position par rapport au substrat puisse être modifiée de manière active et par le fait qu'il est prévu au moins un capteur (21) qui détecte l'incidence de la modification de la position sur la fonction d'au moins un élément d'un microsystème et délivre un signal aux fins de nouveau réglage, c'est-à-dire d'auto-réglage d'éléments optiques (23, 24) et de leurs supports (28).

2. Microsystème intégré selon la revendication 1, caractérisé par le fait qu'il est agencé à des fins de réglage d'un laser à semiconducteur (8) à pompage par diodes le long d'un axe (axe optique 7) et à des fins de commande/réglage/refroidissement de celui-ci ainsi que de couplage et de découplage d'énergie.

3. Microsystème intégré selon l'une des revendications précédentes, caractérisé par le fait qu'il comporte des circuits électroniques (22), notamment des circuits de commande et de réglage pour le système de laser ainsi que leurs connexions, détecteurs (21), actionneurs (27).

4. Microsystème intégré selon l'une des revendications précédentes, caractérisé par le fait qu'il comporte des moyens (12) d'échange de chaleur, notamment pour le refroidissement du système de laser.

5. Microsystème intégré selon l'une des revendications précédentes, caractérisé par le fait que l'auto-réglage actif du laser à semi-conducteur (8) à pompage par diode agit pendant toute la durée de fonctionnement du laser aux fins de maintenir une position de consigne d'au moins certains éléments optiques.

6. Microsystème intégré pour des moyens électriques et des moyens non électriques, notamment des moyens optiques d'un système de laser, caractérisé par le fait qu'il présente un substrat (1) en matériau semi-conducteur monocristal pouvant être soumis à une attaque anisotrope, lequel substrat remplit la fonction mécanique de support pour des éléments d'un laser à semi-conducteur (8) à diode de pompage, tels que optique (14), résonateurs (23, 24), cristal du laser (16) et éléments fluidiques/électroniques (15), par le fait qu'à des fins de positionnement précis des éléments le microsystème est pourvu de moyens auxiliaires de réglage tels que des rainures en V (2) et des cavités qui se présentent sous la forme de structures obtenues par attaque chimique et par le fait que, grâce à des canaux de liquide de refroidissement, le substrat (1) sert simultanément de refroidisseur pour les éléments à puissance élevée.

7. Microsystème intégré selon la revendication 6, caractérisé par le fait que les supports des éléments du laser (8) à pompage par diode qui exigent une très grande précision de réglage, tels que miroirs de résonateur, déviateurs de rayons, concentrateur de faisceau (23 à 26), sont agencés de telle sorte qu'ils peuvent être réglés avec précision au moyen d'actionneurs (27) intégrés dans le substrat (1) par réglage d'une position de consigne, le signal de commande étant obtenu à partir du signal de mesure de détecteurs de rayonnement laser (21) qui avec l'électronique de commande sont intégrés dans le micro-système.

8. Microsystème intégré selon la revendication 6, caractérisé par le fait que des éléments du système de laser dont la position peut être modifiée, juste après la fabrication, sont réglés une fois dans une position d'origine sur le plan de la position, de la distance et analogue, notamment par déplacement dans des rainures en V du substrat (1) et par le fait que d'autres éléments sont figés dans cet état pour la durée de fonctionnement du laser (8) au moyen de masses coulées, d'adhésifs ou brasure ou de soudure.

9. Microsystème intégré selon la revendication 6, caractérisé par le fait que la commande de la position d'éléments du système de laser (8), notamment d'éléments optiques du système, est opérée par voie mécanique/électrique, magnétique, thermique, fluidique, au moyen d'actionneurs (27) ou à l'aide de mécanismes d'entraînement.

10. Microsystème intégré selon la revendication 6, caractérisé par le fait que la commande de la position d'éléments du système de laser (8) notamment d'éléments optiques du système, est opérée par voie fluidique par écoulement d'un fluide qui est envoyé ou évacué.

11. Microsystème intégré selon la revendication 6, caractérisé par le fait que des barrières thermiques sont formées dans le micro-système par les rainures en V (2) obtenues par attaque anisotrope entre des zones comportant des éléments (20) avec des exigences de température différentes.

12. Microsystème intégré selon la revendication 6, caractérisé par le fait que des canaux de refroidissement (12) formés par des rainures en V (2) parallèles sont disposés dans la direction du cristal du substrat semi-conducteur le plus près possible du laser à semi-conducteur (8).

FIG. 1

FIG. 2

FIG. 3

FIG. 4

FIG. 5

p-Typ

n-Typ

FIG. 6

FIG. 7

FIG. 8